Europäisches Patentamt

European Patent Office

Office européen des brevets

(19)

(11) Numéro de publication: **0 090 722**
**B1**

(12) **FASCICULE DE BREVET EUROPEEN**

(45) Date de publication du fascicule du brevet:
27.11.85

(51) Int. Cl.⁴: **H 01 L 29/90,** H 01 L 29/167

(21) Numéro de dépôt: 83400591.0

(22) Date de dépôt: 22.03.83

(54) **Diode rapide.**

(30) Priorité: 30.03.82 FR 8205435

(43) Date de publication de la demande:
05.10.83 Bulletin 83/40

(45) Mention de la délivrance du brevet:
27.11.85 Bulletin 85/48

(84) Etats contractants désignés:
**DE FR GB IT NL**

(56) Documents cités:
**FR - A - 1 576 940**
**US - A - 3 553 536**
**US - A - 3 710 203**
**PATENTS ABSTRACTS OF JAPAN, vol. 6, no. 115,**
**(E-115)993i, 26 juin 1982**

(73) Titulaire: **THOMSON-CSF, 173, Boulevard Haussmann,**
**F-75379 Paris Cedex 08 (FR)**

(72) Inventeur: **Collumeau, Yoland, THOMSON-CSF**
**SCPI 173, bld Haussmann, F-75379 Paris Cedex 08 (FR)**

(74) Mandataire: **Guérin, Michel et al, THOMSON-CSF**
**SCPI 173, Bld Haussmann, F-75379 Paris Cédex 08 (FR)**

ACTORUM AG

# Description

La présente invention concerne une diode rapide pouvant par exemple avoir une fonction de redressement ou de diode roue libre dans un circuit hacheur.

Plus particulièrement, l'invention propose une telle diode ayant des caractéristiques améliorées lors de la commutation de l'état conducteur à l'état bloqué, c'est-à-dire une meilleure caractéristique de blocage.

Bien que cet aspect ne soit pas développé ici, on notera de façon générale qu'une diode ayant de bonnes caractéristiques de commutation au blocage présente aussi une meilleure commutation à l'établissement, c'est-à-dire lors du passage de l'état bloqué à l'état conducteur.

Pour mieux faire comprendre la présente invention, on va définir d'abord les principaux paramètres caractérisant le blocage d'une diode. On rappellera aussi certaines explications théoriques sur les phénomènes physiques intervenant lors du blocage. Néanmoins, même si les théories actuelles sur le blocage s'avèrent erronées, la diode selon l'invention est définie par ses caractéristiques structurelles et une erreur dans l'exposé théorique ne saurait influer sur la présente invention dont les avantages ont été prouvés expérimentalement.

Les fig. 1, 2 et 3 caractérisent des diodes rapides classiques.

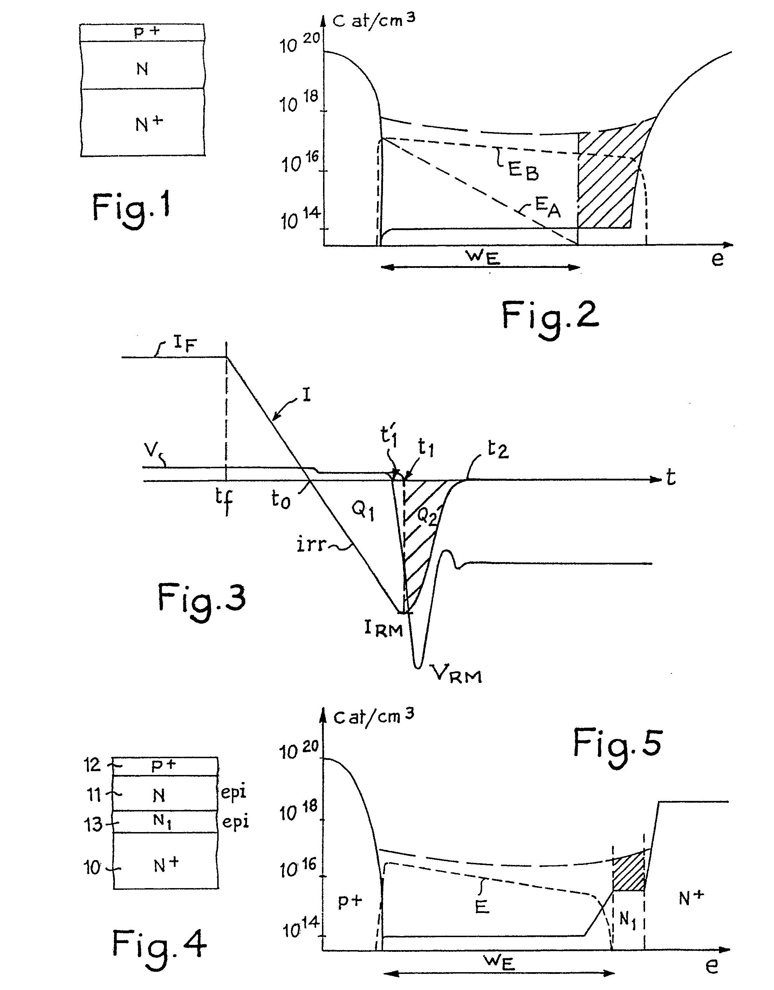

Comme le montre la vue en coupe de la fig. 1, une telle diode est couramment de type PNN$^+$.

La fig. 2 indique en trait plein la concentration en atomes dopants dans une telle diode.

La fig. 3 montre, en fonction du temps, l'évolution du courant dans la diode et de la tension aux bornes de la diode pendant la commutation de blocage.

Comme l'indique la courbe en tirets longs de cette fig. 2, lorsqu'un courant direct passe dans cette diode, une certaine quantité de charges est injectée dans la zone faiblement dopée de type N. Cette quantité de charges ou de porteurs injectés dépend du courant traversant la diode. La quantité de charges emmagasinée pendant la conduction directe et demeurant à l'instant $t_0$ du cycle de commutation (fig. 3) est couramment désignée par le symbole $Q_{00}$ et est appelée charge stockée. Elle s'exprime par une relation du type:

$$Q_0 \# \tau I_F \text{ ou } Q_0 \# \tau^2 dI_F/dt$$

selon la valeur de la durée $t_0$-t par rapport à la valeur de $\tau$ où $\tau$ est la durée de vie des porteurs minoritaires dans la zone de type N de la diode et où $I_F$ est le courant direct dans la diode.

Quand on inverse la tension aux bornes du circuit comprenant la diode ou que le courant est dérivé dans une autre partie du circuit, on ne retrouve pas immédiatement aux bornes de cette diode une tension de valeur égale à celle de la tension inverse appliquée. Au contraire, il s'écoule un certain temps durant lequel la diode peut être assimilée à un court-circuit en inverse, avant qu'elle ne retrouve son pouvoir de blocage.

En effet, pendant la commutation, pour une diode rapide, une partie de la charge $Q_0$ disparaît spontanément par recombinaison interne (liée à la durée de vie des porteurs minoritaires), mais l'autre partie, appelée charge recouvrée $Q_R$, qui intervient essentiellement dans le phénomène étudié est évacuée par le courant inverse circulant dans la diode. C'est cette charge recouvrée qui produit le courant inverse de recouvrement et induit tous les phénomènes de commutation (surtension, échauffement, parasites, etc.).

Le recouvrement inverse peut être décomposé en deux parties (voir aussi la fig. 3).

Dans une première partie, dès l'instant de fermeture $t_f$ de l'interrupteur du circuit de commutation, le courant direct commence à décroître, s'annule et un courant inverse $i_{rr}$ s'établit. La vitesse de décroissance du courant direct, puis de croissance du courant inverse est en général exclusivement imposée par le circuit dans lequel est insérée la diode.

Puis, à partir de l'instant t'1, la diode commence à retrouver son pouvoir de blocage: les abords de la jonction deviennent libres de porteurs (création d'une zone déserte ou zone de charge d'espace), une tension s'établit aux bornes de la diode, le courant inverse croît moins vite. A l'instant t1, la tension inverse appliquée se retrouve totalement aux bornes de la diode et le courant inverse est à son maximum. Entre t0 et t1, une quantité de charge Q1 est évacuée. Il reste à évacuer une charge Q2 correspondant à la zone hachurée en fig. 3 tandis que le courant inverse décroît et s'annule.

Finalement, après l'instant t2, la variation de courant étant nulle, il ne reste aux bornes de la diode que la tension inverse appliquée.

Pour déterminer plus exactement le fonctionnement, il convient d'examiner à quels paramètres physiques correspondent les charges $Q_1$ et $Q_2$. On considérera l'allure de la zone déserte ou zone de charge d'espace dans la diode dans deux cas particuliers. En fig. 2, on a reporté en pointillés serrés des courbes $E_A$ et $E_B$ indiquant la distribution du champ électrique quand la diode est dans l'état bloqué. Dans le cas de la courbe $E_A$, l'épaisseur de la zone N est supérieure à la largeur $W_E$ de la zone déserte. Dans le cas de la courbe $E_B$, la zone déserte s'étend sur toute l'épaisseur de la couche N.

Pendant la période s'étendant entre les instants $t_0$ et $t_1$, on élimine notamment tous les porteurs injectés qui se trouvent dans la région dans laquelle se développe la zone de charge d'espace. Dans le cas de la courbe $E_A$ (couche N épaisse devant l'extension de la zone déserte) il va rester des porteurs injectés après cette première phase et la charge $Q_2$ correspond à des porteurs qui se trouvaient dans la zone hachurée de la fig. 2. Dans le cas de la courbe $E_B$, la charge $Q_2$ est pratiquement nulle et en conséquence la durée s'écoulant entre les instants $t_1$ et $t_2$ est très brève: le courant inverse passe très vite de son amplitude maximale $I_{RM}$ à une valeur nulle. Il résulte de cette variation très rapide du courant la création de surtensions $V_{RM}$ importantes.

Pour réaliser en pratique une diode rapide pour laquelle la charge d'espace a la configuration indiquée par la courbe $E_{A'}$ on part de la tension inverse à obtenir. Celle-ci détermine la résistivité du silicium N à utiliser. Cette donnée étant acquise, on calcule l'extension de la charge d'espace $W_E$ et on choisit l'épaisseur de la couche N, $W_N$, supérieure à $W_E$. On procède en final à une réduction de la durée de vie $\tau$ des porteurs minoritaires (diffusion d'or, de platine; bombardement électronique...); c'est en effet cette donnée physique qui, pour des conditions $I_F$ et $dI_F/dt$ données, gère la quantité de charges stockées $Q_0$ et, à partir de là, la rapidité de commutation de la diode ($t_1 - t_0$, $t_2 - t_0$, $I_{RM}$). On ne peut pas réduire à volonté la durée de vie. Pour que la diode conserve des caractéristiques correctes à l'état conducteur (caractéristique $V_F = f(I_F)$) on est tenu de maintenir la durée de vie au-dessus d'une valeur minimale qui dépend essentiellement de l'épaisseur $W_N$ de la couche N centrale et dont la valeur minimale est proportionnelle à $W_N^2$. On ne peut donc réduire au-delà d'un certain seuil la charge $Q_0 \# \tau I_F$ et partant le temps de recouvrement de la diode.

Ainsi, pour réduire $Q_0$, il faut pouvoir réduire la durée de vie et donc l'épaisseur de la couche N de la diode et passer à une configuration correspondant à la courbe $E_B$ de la fig. 2. On utilise maintenant pour une même tenue en tension inverse une résistivité de silicium beaucoup plus élevée. Sous tension inverse, la décroissance du champ à partir de la jonction sera lente (courbe $E_B$) et on détermine l'épaisseur de la couche N, $W_N$, pour obtenir la tenue en tension visée. On peut réduire cette épaisseur dans un rapport pratiquement égal à 2 par rapport au cas précédent. Ceci permettra donc de réduire la durée de vie à un niveau considérablement plus faible (en principe 4 fois plus faible) et donc d'obtenir des diodes beaucoup plus rapides pour lesquelles la valeur d'$I_{RM}$ est beaucoup plus faible que dans le cas précédent. Mais, comme on l'a vu, l'inconvénient est que la charge $Q_2$ est alors très faible et qu'il se produit de fortes surtensions à la commutation.

C'est l'un des objets principaux de la présente invention que de fournir une diode qui, d'une part, soit extrêmement rapide, et d'autre part, présente une faible surtension à la commutation.

Pour atteindre ces objets ainsi que d'autres, la présente invention prévoit une diode PNN$^+$ à commutation rapide à l'ouverture (au blocage) comprenant, sur un substrat de type N$^+$ à fort niveau de dopage, une première couche de type N formée par épitaxie à faible niveau de dopage dans laquelle la durée de vie des porteurs est fortement réduite et une couche de type P à fort niveau de dopage, caractérisée en ce qu'elle comprend en outre une deuxième couche épitaxiée de type N entre le substrat et la première couche et dont la concentration en impuretés est intermédiaire entre celle du substrat et celle de la première couche, l'épaisseur de cette deuxième couche étant telle que, pour la tension nominale de fonctionnement à l'état bloqué, la zone déserte atteigne cette couche sans néanmoins qu'elle soit complètement désertée, et la concentration en impuretés de la deuxième couche $N_1$ étant inférieure à la densité des porteurs libres en excès au moment de la commutation pour les conditions de fonctionnement nominal de la diode (courant nominal, vitesse de coupure de ce courant).

Les caractéristiques et avantages de la présente invention seront exposés plus en détail dans la description suivante de modes de réalisation particuliers faite en relation avec les figures jointes parmi lesquelles:

— les fig. 1 à 3 ont été décrites précédemment pour rappeler l'état de la technique,

— la fig. 4 est une vue en coupe schématique d'une diode selon la présente invention,

— la fig. 5 représente diverses courbes caractéristiques de la structure et du fonctionnement d'une diode selon la présente invention,

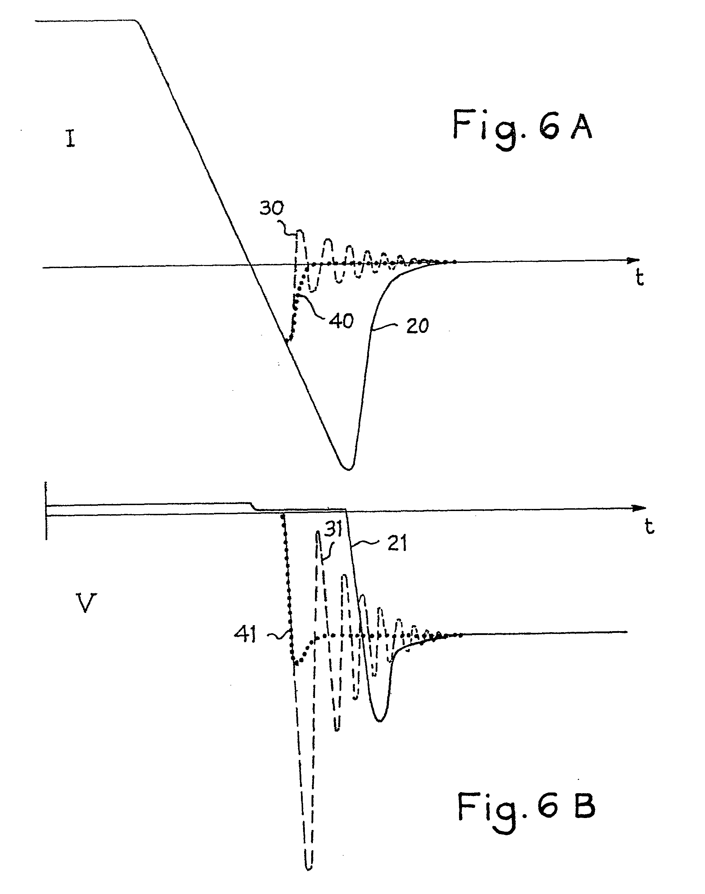

— les fig. 6A et 6B représentent respectivement la variation du courant et de la tension lors du blocage pour une diode selon la présente invention en comparaison de diodes classiques.

La fig. 4 représente une vue en coupe très schématique d'une diode selon la présente invention. Cette diode est élaborée à partir d'un substrat 10 de type N$^+$ et comprend les couches classiques 11 de type N et 12 de type P$^+$. En outre, cette diode comprend une couche intermédiaire 13 de type N, dite N$_1$, entre le substrat 10 de type N$^+$ et la couche faiblement dopée 11 de type N. Comme cela est classique, les couches 10 et 12, respectivement de type N$^+$ et P$^+$, ont des niveaux de dopage aussi élevés que possible, supérieurs à $10^{18}$ atomes/cm$^3$. La couche 11, quasiment intrinsèque, a un niveau de dopage de l'ordre de $10^{13}$ à quelques $10^{14}$ atomes/cm$^3$. Dans une configuration courante, la couche N1 a un niveau de dopage de l'ordre de quelques $10^{14}$ à $10^{16}$ atomes/cm$^3$, mais on verra que ce niveau de dopage est fonction des caractéristiques de fonctionnement nominal de la diode. Les couches N$_1$ et N sont de préférence formées par épitaxies successives sur le substrat N$^+$. La couche P$^+$ est par exemple formée par diffusion dans la couche N.

La fig. 5 représente en trait plein la variation de concentration de dopants dans la diode en fonction de l'épaisseur.

En tiretés longs, on a indiqué la concentration de porteurs libres en excès à l'instant $t_0$ du cycle de commutation. Cette quantité de porteurs dépend du courant nominal dans la diode et/ou de la vitesse de commutation imposée par le circuit.

La courbe en tiretés serrés indique la distribution du champ électrique quand la diode est dans l'état bloqué, $W_E$ désignant l'extension de la zone déserte quand la diode est dans l'état bloqué pour la tension nominale qu'elle est amenée à supporter.

En reprenant les notations de la fig. 3, lors du blocage de la diode, entre les instants $t_0$ et $t_1$, les porteurs injectés se trouvant dans la zone qui va être désertée à l'instant $t_1$ sont éliminés, et c'est une partie des porteurs situés dans la zone hachurée de la fig. 5 qui va correspondre à la charge $Q_2$ évacuée entre les instants t1 et t2.

Selon l'invention, il est essentiel que ces porteurs soient en nombre suffisant pour que la transition entre les instants t1 et t2 ne soit pas trop courte

et que l'on ne provoque pas ainsi une surtension $V_{RM}$ trop importante.

Pour ajuster la durée s'écoulant entre les instants t1 et t2, on jouera selon la présente invention sur l'épaisseur et sur le niveau de dopage de la couche N1. Ce niveau de dopage, intermédiaire entre les niveaux de dopage des couches N et $N^+$, devra être inférieur à la densité de charge injectée lors de la conduction directe.

Les fig. 6A et 6B reproduisent des oscillogrammes réalisés par le demandeur et illustrant le fonctionnement de diodes selon la présente invention par rapport à des diodes de l'art antérieur.

Les courbes 20, 30, 40 représentent les variations du courant I en fonction du temps et les courbes 21, 31, 41, les variations de la tension V en fonction du temps aux bornes d'une diode dans le cas d'une diode rapide «épaisse», d'une diode très rapide selon l'art antérieur, et d'une diode selon la présente invention.

Les courbes 20 et 21 correspondent au cas d'une diode rapide, classique, pour laquelle l'épaisseur $W_N$ de la couche N est supérieure à l'extension $W_E$ de la zone de charge d'espace: la charge $Q_1$ est importante et par conséquent $I_{RM}$ a une valeur élevée et la charge $Q_2$ est suffisante pour qu'il n'y ait pas d'oscillations de tension.

Les courbes 30 et 31 représentent ce qui se passe dans le cas d'une diode telle qu'illustrée en fig. 1 et 2 quand l'épaisseur $W_N$ de la zone N devient inférieure à l'étendue que devrait normalement occuper la zone de charge d'espace dans une zone de ce type. Lors du blocage, la charge $Q_1$ étant faible, $I_{RM}$ est nettement inférieur à sa valeur précédente, mais il se produit de très fortes surtensions et oscillations de tension et de courant en raison de la très faible valeur de la charge $Q_2$.

Conformément à la présente invention, comme le montrent les courbes 40 et 41, ces surtensions sont évitées avec une diode comprenant une couche épitaxiée supplémentaire N1. La diode selon la présente invention cumule les avantages des deux types de diodes rapides selon l'art antérieur: faible valeur de $t_1$-$t_0$ et de $I_{RM}$ et limitation de la surtension et des suroscillations de tension. Des essais réalisés par l'homme de l'art permettront, pour une tension et un courant nominaux choisis de fonctionnement de la diode, ainsi que pour une vitesse de coupure $dI_F/dt$ supérieure à un seuil déterminé, de déterminer l'épaisseur et le niveau de dopage de la couche épitaxiée N1 en fonction du niveau de surtension toléré.

A titre d'exemple, des oscillogrammes correspondant aux courbes 40 et 41, pour lesquelles le courant à l'état passant était de 30A et la tension inverse de 200V, $dI_F/dt$ étant de 200 A/ms, ont été relevés pour une diode ayant une surface de jonction de 0,3 cm² avec les caractéristiques suivantes:
— couche $P^+$: concentration superficielle $C_s$=1,5 10²⁰ at/cm³, épaisseur 20 μ,
— couche N: épaisseur $W_N$=25 μ résistivité 35 ω·cm (1,4 10¹⁴ at/cm³)
— couche $N_1$: épaisseur $W_{N1}$=15 μ résistivité 5 ω·cm (9,6 10¹⁴ at/cm³), la durée de vie ayant été réduite par diffusion d'or à 935°C.

De même dans le cas d'un courant à l'état passant de 90A et d'une tension inverse de 1000V, $dI_F/dt$ étant égal à 90A/ms, une diode d'une surface de 0,3 cm² peut être construite avec les paramètres suivants:
— couche $P^+$: $C_s$=1,5 10²⁰ at/cm³, épaisseur: 20 μ,
— couche $N^+$: $W_N$=60 μ résistivité 60 ω·cm (1,8 10¹³ at/cm³)
— couche $N_1$: $W_{N1}$=15 μ résistivité 2 ω·cm (1,5 10¹⁵ at/cm³) la durée de vie étant réduite par diffusion d'or à 910°C.

La présente invention n'est pas limitée aux modes de réalisation précédemment décrits; elle en englobe au contraire les diverses variantes et généralisations incluses dans le domaine des revendications ci-après. Par exemple, la couche N1, au lieu d'avoir une concentration constante, peut présenter une concentration en impuretés variable, plus faible du côté de la couche N et plus forte du côté du substrat $N^+$. Ainsi, cette concentration peut varier continuement ou par paliers de la valeur de la concentration dans la couche N à une valeur supérieure correspondant aux ordres de grandeur de concentration indiqués précédemment.

## Revendications

1. Diode $PNN^+$ à commutation rapide à l'ouverture comprenant sur un substrat (10) de type $N^+$ à fort niveau de dopage, une première couche (11) de type N à faible niveau de dopage dans laquelle la durée de vie des porteurs est fortement réduite et une couche (12) de type P à fort niveau de dopage, caractérisée en ce qu'elle comprend en outre une deuxième couche (13) de type N (couche $N_1$) entre le substrat et la première couche et dont la concentration en impuretés est intermédiaire entre celle du substrat et celle de la première couche, l'épaisseur de cette deuxième couche étant telle que, pour la tension nominale du fonctionnement à l'état bloqué, la zone déserte atteigne cette couche sans néanmoins qu'elle soit complètement désertée, et la concentration en impuretés de la deuxième couche $N_1$ étant inférieure à la densité des porteurs libres en excès au moment de la commutation pour les conditions de fonctionnement nominal de la diode (courant nominal, vitesse de coupure de ce courant).

2. Diode selon la revendication 1, caractérisée en ce que les deuxième et première couches sont formées par épitaxies successives.

3. Diode $PNN^+$ selon la revendication 1, caractérisée en ce que la durée de vie des porteurs dans la première couche de type N est réduite par diffusion d'or ou de platine.

4. Diode $PNN^+$ selon l'une quelconque des revendications 1 à 3, caractérisée en ce que la première couche N a un niveau de dopage de l'ordre de 10¹³ à quelque 10¹⁴ atomes/cm³, et la deuxième couche $N_1$ de l'ordre de quelque 10¹⁴ à 10¹⁶ at/cm³.

5. Diode $PNN^+$ selon l'une quelconque des revendications 1 à 4, caractérisée en ce que la deuxième couche $N_1$ a une épaisseur de l'ordre de 10 à 50 μ.

6. Diode PNN$^+$ selon l'une quelconque des revendications 1 à 5, caractérisée en ce que la concentration de la deuxième couche $N_1$ n'est pas constante sur l'épaisseur de cette couche.

## Patentansprüche

1. PNN$^+$-Diode mit schnellem Öffnungs-Schaltverhalten, die auf einem Substrat (10) vom Typ N$^+$ und mit hohem Dotierungsniveau eine erste Schicht (11) vom Typ N mit niedrigem Dotierungsniveau, worin die Lebensdauer der Träger stark vermindert ist, und eine Schicht (12) vom Typ P mit hohem Dotierungsniveau aufweist, dadurch gekennzeichnet, dass sie ferner eine zweite Schicht (13) vom Typ N (Schicht $N_1$) zwischen dem Substrat und der ersten Schicht aufweist, deren Konzentration an Verunreinigungen zwischen der des Substrats und der der ersten Schicht liegt, wobei die Dicke dieser zweiten Schicht derart ist, dass für die Nennspannung im Sperrbetrieb die verarmte Zone diese Schicht erreicht, ohne dass sie jedoch vollständig verarmt ist, und die Konzentration der zweiten Schicht $N_1$ an Verunreinigungen geringer als die Dichte der freien Träger ist, die überschüssig sind im Moment des Umschaltens für die Nenn-Betriebsbedingungen der Diode (Nennstrom, Abschaltgeschwindigkeit für diesen Strom).

2. Diode nach Anspruch 1, dadurch gekennzeichnet, dass die zweite und die erste Schicht nacheinander epitaktisch gebildet sind.

3. PNN$^+$-Diode nach Anspruch 1, dadurch gekennzeichnet, dass die Dauer der Träger in der ersten Schicht vom Typ N durch Diffusion von Gold oder Platin vermindert ist.

4. PNN$^+$-Diode nach einem der Ansprüche 1 bis 3, dadurch gekennzeichnet, dass die erste Schicht N ein Dotierungsniveau in der Grössenordnung von $10^{13}$ bis einige $10^{14}$ Atome/cm³ und die zweite Schicht $N_1$ in der Grössenordnung von einigen $10^{14}$ bis $10^{16}$ Atome/cm³ aufweist.

5. PNN$^+$-Diode nach einem der Ansprüche 1 bis 4, dadurch gekennzeichnet, dass die zweite Schicht $N_1$ eine Dicke in der Grössenordnung von 10 bis 50 μ aufweist.

6. PNN$^+$-Diode nach einem der Ansprüche 1 bis 5, dadurch gekennzeichnet, dass die Konzentration der zweiten Schicht $N_1$ über die Dicke dieser Schicht nicht konstant ist.

## Claims

1. PNN$^+$ diode with rapid switching upon blocking, comprising on a substrate (10) of N$^+$ type with high doping level a first layer (11) of N type with low doping level wherein the lifetime of the carriers is highly reduced and a layer (12) of P type with high doping level, characterized in that it further comprises a second layer (13) of N type (layer $N_1$) between the substrate and the first layer and the impurities concentration whereof is intermediate between that of the substrate and that of the first layer, the thickness of this second layer being such that for the nominal operating voltage in the blocked state, the depletion zone reaches that layer without however being completely depleted, and the impurity concentration of the second layer ($N_1$) being less than the density of the free carriers which are in excess at the moment of switching under nominal operation conditions of the diode (nominal current, blocking speed of this current).

2. Diode according to claim 1, characterized in that the second and first layers are successively formed by epitaxy.

3. PNN$^+$ diode according to claim 1, characterized in that the lifetime of the carriers in the first layer of N type is reduced by diffusion of gold or platinum.

4. PNN$^+$ diode according to any of claims 1 to 3, characterized in that the first N layer has a doping level of the order of $10^{13}$ to some $10^{14}$ atomes/cm³ and the second layer $N_1$ of the order of some $10^{14}$ to $10^{16}$ at./cm³.

5. PNN$^+$ diode according to any of claims 1 to 4, characterized in that the second layer $N_1$ has a thickness of the order of 10 to 50 μ.

6. PNN$^+$ diode according to any of claims 1 to 5, characterized in that the concentration of the second layer $N_1$ is not constant across the thickness of this layer.

0 090 722

Fig.1

Fig.2

Fig.3

Fig.4

Fig.5

7

Fig. 6 A

Fig. 6 B